# EUROPEAN PATENT APPLICATION

(11) **EP 4 700 417 A1**
(43) Date of publication of application: **25.02.2026**
(21) Application number: 24792518.3
(22) Date of filing: 04.04.2024
(51) Int. Cl.: G01R 33/02, G01D 5/245

(54) **SELF-POWERED SENSOR**

(30) Priority: 17.04.2023 JP 2023067425
(71) Applicant: Oriental Motor Co., Ltd., Tokyo 111-0056 (JP); Ozeki, Sakao, Kakegawa-shi, Shizuoka, 436-0061 (JP)
(72) Inventor: HOUDA, Akihiko, Tsukuba-shi, Ibaraki 300-2635 (JP); SOMEYA, Masayuki, Tsukuba-shi, Ibaraki 300-2635 (JP); OZEKI, Sakao, Kakegawa-shi, Shizuoka 436-0061 (JP)
(74) Representative: Witte, Weller & Partner Patentanwälte mbB
(86) International application number: PCT/JP2024/013899
(87) International publication number: WO 2024/219243

(57) **Abstract**

A power generation sensor includes a magnetic wire configured to exhibit a large Barkhausen effect by an alternating magnetic field applied by a magnetic field source, a coil wound around the magnetic wire, a pair of magnetically-soft components that are respectively magnetically coupled to both end portions of the magnetic wire. The pair of magnetically-soft components are bonded and fixed to the both end portions of the magnetic wire by magnetically-soft resins made of a resin containing a magnetically-soft material. In an example embodiment, the pair of magnetically-soft components are placed to be positioned between the magnetic wire and the magnetic field source, and the both end portions of the magnetic wire and surfaces of the pair of magnetically-soft components that do not oppose the magnetic field source are bonded and fixed to each other by the magnetically-soft resins.

## Description

### RELATED APPLICATION

This application claims the benefit of priority to Japanese Patent Application No. 2023-67425, filed on April 17, 2023, the disclosure of which is entirely incorporated herein by reference.

### TECHNICAL FIELD

The present invention relates to a power generation sensor that generates electric power in response to a change in magnetic field.

### BACKGROUND ART

Magnetic wires having a large Barkhausen effect (large Barkhausen jump) are known in the name of Wiegand wire or pulse wire. Such a magnetic wire includes a core portion, and a shell portion provided around the core portion. One of the core portion and the shell portion is a soft (magnetically soft) layer of which the magnetization direction is reversed even by application of a weak magnetic field, and the other of the core portion and the shell portion is a hard (magnetically hard) layer of which the magnetization direction is reversed only by application of a strong magnetic field. A power generation sensor is produced by winding a coil around the magnetic wire.

When the hard layer and the soft layer are magnetized in the same direction axially of the wire and the strength of an external magnetic field applied in a direction opposite to that magnetization direction is increased to a certain magnetic field strength, the magnetization direction of the soft layer is reversed. The reversal of the magnetization direction starts at a certain position of the magnetic wire to propagate to the entire wire, whereby the magnetization direction of the soft layer is totally reversed. At this time, the large Barkhausen effect is exhibited to induce a pulse signal in the coil wound around the magnetic wire. When the external magnetic field strength is further increased to another certain magnetic field strength, the magnetization direction of the hard layer is reversed.

In order to provide the large Barkhausen effect, it is necessary to reverse the magnetization direction of only the soft layer in a state such that the magnetization directions of the hard layer and the soft layer are consistent. Even if the magnetization direction of only the soft layer is reversed in a state such that the magnetization directions of the hard layer and the soft layer are inconsistent, no pulse signal is generated or a pulse signal having a very small amplitude is generated.

In order to maximize the available electric power, it is important that the reversal of the magnetization direction of the soft layer propagates to the entire magnetic wire from a state such that the magnetization direction of the magnetic wire is entirely consistent. If the magnetization direction of the magnetic wire is partly inconsistent, a pulse signal having a very small amplitude is generated. Therefore, it is preferred to apply a uniform magnetic field to the entire magnetic wire.

The magnetic characteristics of the magnetic wire as described above are obtained formed through processing such as wire drawing, heat treatment, and twisting to apply stress thereto such that the stress remains on the magnetic wire. For this reason, in a subsequent step, when another stress is applied, an uncertain and unexpected distortion occurs in the magnetic wire. As a result, the magnetic characteristics change, and the pulse signal is not stable.

Techniques for the power generation sensor are described in PTL 1 to PTL 3.

In PTL 1, a bobbin is provided such that an uncertain and unexpected distortion does not occur in a magnetic wire. The bobbin protects the magnetic wire from an external force, a temperature change, and a vibration. However, a demagnetization field generated at both end portions of the magnetic wire cannot be suppressed, and a uniform magnetic field cannot be applied to the entire magnetic wire.

PTL 2 discloses a magnetic sensor configured to hold a magnetic wire in a glass tube to prevent a distortion of the magnetic wire, and support both end portions of the glass tube in cylindrical recesses of a guide member made of a magnetically-soft material. PTL 2 states that this arrangement suppresses a demagnetization field generated in the magnetic wire to stabilize a pulse signal output. However, there is a gap between the magnetic wire and the guide member according to a thickness of the glass tube, and as a result, magnetic coupling between the guide member and the magnetic wire is weakened. For this reason, the induction efficiency of the magnetic flux collected by the guide member to the magnetic wire is lowered, and the large Barkhausen effect inherent to the magnetic wire cannot be sufficiently caused.

PTL 3 discloses a power generation device having an arrangement in which two structural portions made of magnetically-soft material are provided at both end portions of a magnetic wire and the magnetic wire is pressed by the magnetically-soft components. PTL 3 states that this arrangement suppresses a demagnetization field generated in the magnetic wire to stabilize a pulse signal output. While this arrangement can strengthen the magnetic coupling between the magnetically-soft component and the magnetic wire, stress is applied to the magnetic wire by applying pressure to the magnetic wire at the two structural portions made of magnetically-soft material. For this reason, an uncertain and unexpected distortion occurs in the magnetic wire, and a change occurs in the magnetic characteristics. Thus, the pulse signal is not stable. In addition, even when pressure is applied between the magnetic wire and the magnetically-soft component to bring the magnetic wire and the magnetically-soft component into contact with each other, the magnetic wire and the magnetically-soft component partially come into contact with each other, and a gap remains between the magnetic wire and the magnetically-soft component. As a result, sufficient magnetic coupling cannot be obtained.

### CITATION LIST

### PATENT LITERATURE

PTL 1: JP 7021839
PTL 2: JP 2598453
PTL 3: WO 2021/200361 A1

### SUMMARY OF INVENTION

### PROBLEMS TO BE SOLVED BY INVENTION

In order to apply a magnetic field that is parallel to the axial direction and has a uniform strength to the entire magnetic wire, it is not sufficient to simply place the power generation sensor, and it is necessary to place magnetically-soft components having a function of suppressing a demagnetization field and a function of collecting a magnetic field from a magnetic field source at both end portions of the magnetic wire. Further, in order to efficiently improve these functions, strong magnetic coupling is required between a magnetic wire and a magnetically-soft component. In this case, it is necessary to provide a structure that prevents an uncertain and unexpected distortion from occurring in the magnetic wire.

In an arrangement shown in PTL 2, an unintended stress on the magnetic wire is avoided by the glass tube, but there is a problem that magnetic coupling is weakened. PTL 3 discloses an arrangement capable of strengthening magnetic coupling, but there is a problem that an unintended stress is applied to the magnetic wire.

Therefore, an example embodiment of the present invention provides a power generation sensor having a structure in which an unintended stress is not applied to a magnetic wire and strong magnetic coupling between the magnetic wire and a magnetically-soft component having a magnetism collecting function is formed.

### SOLUTION TO PROBLEMS

An example embodiment of the present invention provides a power generation sensor having the following exemplary features.
1. A power generation sensor including,
   a magnetic wire configured to exhibit a large Barkhausen effect by an alternating magnetic field applied by a magnetic field source,
   a coil wound around the magnetic wire, and
   a pair of magnetically-soft components that are respectively magnetically coupled to both end portions of the magnetic wire, in which
   the pair of magnetically-soft components are bonded and fixed to both end portions of the magnetic wire by magnetically-soft resins made of a resin containing a magnetically-soft material.

With this arrangement, the magnetic field of the magnetic field source is induced to both end portions of the magnetic wire by the pair of magnetically-soft components. Both end portions of the magnetic wire are bonded and fixed by the magnetically-soft resins (resins containing a magnetically-soft material). Since both end portions of the magnetic wire are connected to the magnetically-soft components through the magnetically-soft resins, the magnetic coupling between the magnetic wire and the magnetically-soft components is strengthened by the magnetically-soft resins. Therefore, the demagnetization field at both end portions of the magnetic wire can be suppressed, and a magnetic field in the axial direction can be applied over a wide range in the axial direction of the magnetic wire.

In addition, by using the magnetically-soft resins having appropriate hardness (having appropriate flexibility), a design can be made such that no stress is applied to the magnetic wire. Therefore, it is possible to implement a power generation sensor capable of sufficiently causing the large Barkhausen effect and obtaining a high-output signal. In addition, since the resins having flexibility are interposed between the magnetic wire and the magnetically-soft components, excellent durability and resistance to vibration and temperature change can be achieved as well.

2. The power generation sensor according to clause 1, in which
the pair of magnetically-soft components are placed to be positioned between the magnetic wire and the magnetic field source, and
the both end portions of the magnetic wire and surfaces of the pair of magnetically-soft components that do not oppose the magnetic field source are bonded and fixed to each other by the magnetically-soft resins.

With this arrangement, the pair of magnetically-soft components do not include structural portions on a side of the magnetic wire that is opposite to the magnetic field source, and have surfaces opened on the side that does not oppose the magnetic field source. Both end portions of the magnetic wire are bonded and fixed to the surfaces by the magnetically-soft resins. Therefore, when the power generation sensor is assembled, it is not necessary to insert the magnetic wire into openings of the magnetically-soft components. In addition, since the magnetic wire and the magnetically-soft components can be coupled to each other by bonding and fixing using the magnetically-soft resins, a separate component for pressing the magnetic wire and bringing the magnetic wire into contact with the magnetically-soft components is not required. Therefore, it is possible to achieve mechanical coupling and good magnetic coupling between the magnetic wire and the magnetically-soft components without causing an unintended distortion in the magnetic wire, and to provide a power generation sensor that is excellent in assemblability.

In a case where the magnetic component has a structural portion on the side of the magnetic wire that is opposite to the magnetic field source, such a structural portion does not contribute to the magnetism collecting function and has a function of strengthening the magnetic coupling with the magnetic wire. On the other hand, according to the arrangement of the example embodiment in which the magnetic coupling between the magnetic wire and the magnetic components is strengthened by the magnetically-soft resins, a structural portion on the side opposite to the magnetic field source is not required.

3. The power generation sensor according to clause 1 or 2, in which hardness of the magnetically-soft resin is not higher than durometer A90 (90 points in a type A durometer according to JIS K 6253).

With this arrangement, since the magnetically-soft resin is rubber-like and has high elasticity, it is possible to avoid occurrence of an unintended distortion in the magnetic wire. In addition, peeling of the magnetically-soft resin at an interface between the magnetic wire and the magnetically-soft component can be suppressed, and thus, a power generation sensor having excellent durability can be implemented.

4. The power generation sensor according to any one of clauses 1 to 3, in which
the pair of magnetically-soft components are made of a magnetically-soft material, which has a coercivity not higher than that of the magnetic wire and has a relative permeability of not lower than 500, and
the magnetically-soft resin is a resin obtained by mixing a magnetically-soft powder made of a magnetically-soft material, which has a coercivity not higher than that of the magnetic wire and has a relative permeability of not lower than 500.

The magnetically-soft material as described above has characteristics such as low magnetic resistance, low hysteresis, and low self-dielectric. Thus, even if a high-frequency alternating magnetic field generated when the magnetic field source is moved at a higher speed is applied, the output characteristics of the power generation sensor are not significantly influenced. Specifically, the magnetically-soft material is preferably made of an Ni-based ferrite material or an Mn-based ferrite material. The magnetically-soft material of the magnetically-soft component and the magnetically-soft material of the magnetically-soft powder may be the same kind or different kinds.

5. The power generation sensor according to clause 4, in which a mixing ratio of the magnetically-soft powder in the magnetically-soft resin is not lower than 50 wt% and not higher than 90 wt% (a lower limit of the range is preferably 55 wt%, and more preferably 60 wt%, and an upper limit of the range is preferably 85 wt%, and more preferably 80 wt%).

With this arrangement, the magnetically-soft resin is rubber-like and has high elasticity without impairing resin characteristics such as viscosity, hardness, and curing, and characteristics of the magnetically-soft powder such as magnetic permeability, a coercivity, and magnetic flux density, and thus, the magnetic coupling between the magnetic wire and the magnetically-soft components can be reliably strengthened.

6. The power generation sensor according to any one of clauses 1 to 5, in which the pair of magnetically-soft components include rectangular parallelepiped portions (that is, a part or the whole of the magnetically-soft component is a rectangular parallelepiped shape).

With this arrangement, in a case where the magnetic field source is a magnet, there is an advantage that various magnetization directions of the magnet can be adopted.

The respective magnetically-soft components may have rectangular parallelepiped shapes as a whole, or a part of the magnetically-soft components may have rectangular parallelepiped shapes. In addition, the magnetically-soft components may be configured by a combination of a plurality of portions each having a rectangular parallelepiped shape.

7. The power generation sensor according to any one of clauses 1 to 6, in which the pair of magnetically-soft components include axially-parallel portions that extend in an axial direction of the magnetic wire between the magnetic field source and the coil.

With this arrangement, the axially-parallel portions can have a magnetic shielding function of shielding a magnetic flux toward an intermediate portion of the magnetic wire in the axial direction. Therefore, for example, in a case where the magnetic field source is a multi-pole magnet, there is an advantage that a magnetization pitch can be narrower than a length of the magnetic wire.

8. The power generation sensor according to any one of clauses 1 to 7, in which the pair of magnetically-soft components are placed to be positioned between the magnetic wire and the magnetic field source, and as seen from the axial direction of the magnetic wire, centers of the pair of magnetically-soft components are positioned on a straight line drawn from a center of the magnetic wire in a direction opposing the magnetic field source.

In other words, assuming a flat plane passing through the central axis of the magnetic wire, the flat plane parallel to a direction of the magnetic wire opposing the magnetic field source, centers of the pair of magnetically-soft components are placed on the plane.

With this arrangement, an alternating magnetic field of the magnetic field source that is magnetically collected by the magnetically-soft components is uniformly induced to the magnetic wire.

9. The power generation sensor according to any one of clauses 1 to 8, in which
the pair of magnetically-soft components are placed to be positioned between the magnetic wire and the magnetic field source,
the both end portions of the magnetic wire and surfaces of the pair of magnetically-soft components that do not oppose the magnetic field source are bonded and fixed to each other by the magnetically-soft resins, and
the pair of magnetically-soft components have grooves or ridges that extend in the axial direction of the magnetic wire on surfaces which do not oppose the magnetic field source.

With this arrangement, the magnetic wire can be easily positioned, and can be bonded and fixed to the pair of magnetically-soft components. Therefore, the power generation sensor with good assemblability can be implemented.

10. The power generation sensor according to any one of clauses 1 to 9, further including,
a pair of surface-mounting external terminal electrodes that are respectively provided on the pair of magnetically-soft components so as to oppose the magnetic field source, in which
at least one of the pair of magnetically-soft components or the magnetically-soft resin is an insulator.

This arrangement can reduce the number of components of the power generation sensor. Thus, the power generation sensor is of surface-mounting type having a simple and smaller-size structure. Since the pair of magnetically-soft components and/or the magnetically-soft resins are insulators, the pair of external terminal electrodes can be prevented from being short-circuited through the magnetic wire.

Typically, both ends of the coil are respectively connected to the pair of external terminal electrodes.

The above and other objects, features and advantages of the present invention will become more apparent from the following description of the example embodiments with reference to the attached drawings.

### BRIEF DESCRIPTION OF DRAWINGS

[FIGS. 1A-1C] FIG. 1A is a perspective view of a power generation sensor according to a first example embodiment, FIG. 1B is a front view of the power generation sensor, and FIG. 1C is a cross-sectional view of the power generation sensor.
[FIG. 1D] FIG. 1D is a cross-sectional view illustrating a modification related to placement of magnetically-soft resins.
[FIG. 2] FIG. 2 is a perspective view illustrating a modification example 1 of the first example embodiment.
[FIG. 3] FIG. 3 is a perspective view illustrating a modification example 2 of the first example embodiment.
[FIGS. 4A-4B] FIG. 4A is a perspective view illustrating a modification example 3 of the first example embodiment, and
FIG. 4B is a cross-sectional view of the power generation sensor.
[FIG. 5A] FIG. 5A is a perspective view illustrating an example of a device using the power generation sensor of FIG. 2.
[FIG. 5B] FIG. 5B is a perspective view illustrating an example of a device using the power generation sensor of FIG. 3.
[FIG. 5C] FIG. 5C is a perspective view illustrating an example of a device using the power generation sensor of FIG. 4A and FIG. 4B.
[FIGS. 6A-6B] FIG. 6A and FIG. 6B illustrate a model structure of a comparative example.
[FIGS. 7A-7C] FIG. 7A is a perspective view of a power generation sensor according to a second example embodiment, FIG. 7B is a front view of the power generation sensor, and FIG. 7C is a cross-sectional view of the power generation sensor.
[FIGS. 8A-8C] FIG. 8A is a perspective view illustrating a modification example 1 of the second example embodiment, FIG. 8B is a front view of the power generation sensor, and FIG. 8C is a cross-sectional view of the power generation sensor.
[FIGS. 9A-9C] FIG. 9A, FIG. 9B, and FIG. 9C illustrate a modification example 2 of the second example embodiment.
[FIGS. 9D-9G] FIG. 9D, FIG. 9E, FIG. 9F, and FIG. 9G illustrate a modification example 2 of the second example embodiment.
[FIGS. 10A-10B] FIG. 10A and FIG. 10B are perspective views illustrating a modification example 3 of the second example embodiment.
[FIG. 11] FIG. 11 is a perspective view illustrating an arrangement of a power generation sensor according to a third example embodiment.

### DESCRIPTION OF EXAMPLE EMBODIMENTS

The present invention will hereinafter be described based on the example embodiments shown in the drawings. However, it should be understood that the invention be not limited by the following example embodiments.

### [First Example Embodiment]

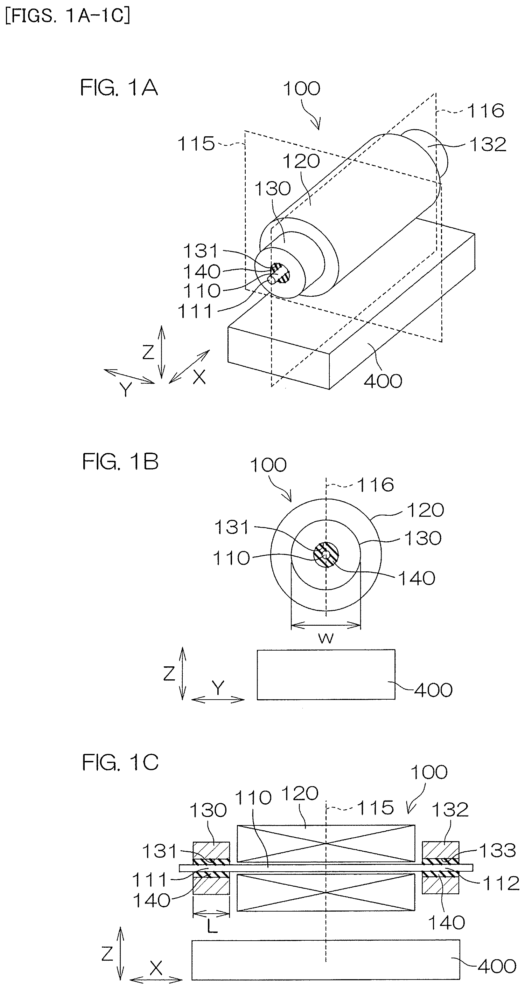

FIG. 1A is a perspective view of a power generation sensor 100 according to a first example embodiment, FIG. 1B is a front view of the power generation sensor 100 as seen in an X direction in FIG. 1A, and FIG. 1C is a cross-sectional view of the power generation sensor 100 on a plane 116 as seen in a Y direction in FIG. 1A.

The power generation sensor 100 includes a magnetic wire 110 configured to exhibit a large Barkhausen effect by an alternating magnetic field applied by a relative movement with respect to a magnetic field source 400, a coil 120 wound around the magnetic wire 110, and a pair of magnetically-soft components 130 and 132. The coil 120 is wound around the magnetic wire 110 such that a first end portion 111 and a second end portion 112 of the magnetic wire 110 are exposed with the same length from the coil 120. In this example embodiment, the coil 120 is wound around the magnetic wire 110 between the pair of magnetically-soft components 130 and 132. In the pair of magnetically-soft components 130 and 132, circular-shaped openings 131 and 133 that are larger than an outer diameter of the magnetic wire 110 are formed. The first end portion 111 and the second end portion 112 of the magnetic wire 110 are respectively inserted into the openings 131 and 133. In the openings 131 and 133, magnetically-soft resins 140 (illustrated by hatching lines for clarity, the same applies to the other drawings) are disposed. The first end portion 111 of the magnetic wire 110 and an inner circumferential surface of the opening 131 of the magnetically-soft component 130 are bonded to each other by the magnetically-soft resin 140, and the second end portion 112 of the magnetic wire 110 and an inner circumferential surface of the opening 133 of the magnetically-soft component 132 are bonded to each other by the magnetically-soft resin 140.

The X direction is a direction in which the central axis of the magnetic wire 110 extends, and is hereinafter referred to as "axial direction X." In addition, a direction orthogonal to the axial direction X and in which the magnetic wire 110 opposes the magnetic field source 400 is referred to as "axially-orthogonal direction Z." The Y direction is a direction orthogonal to both the axial direction X and the axially-orthogonal direction Z, corresponds to a width direction of the power generation sensor 100, and thus is hereinafter referred to as "width direction Y."

The pair of magnetically-soft components 130 and 132 have the same arrangement in a tubular shape (in this example, a cylindrical shape), and are configured to be symmetrical to each other with respect to a symmetry plane 115 (a virtual plane to be used to describe the geometric layout) orthogonal to the axial direction X at the center of the magnetic wire 110 in the axial direction X.

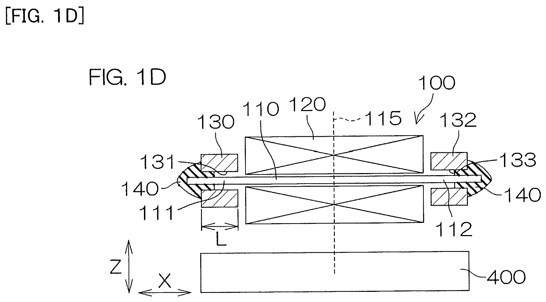

As illustrated in FIG. 1, the magnetically-soft resins 140 are in contact with the entire circumferences of the end portions 111 and 112 of the magnetic wire 110, and are in contact with the entire inner circumferential surfaces of the openings 131 and 133 of the magnetically-soft components 130 and 132. The openings 131 and 133 have a circular shape in this example, but may have another shape such as a square shape.

The magnetically-soft resins 140 are prepared by mixing a magnetically-soft powder (a powder containing a magnetically-soft material) and a resin such as silicone, urethane, or epoxy. The magnetically-soft resins 140 have fluidity until the magnetically-soft resins 140 are placed in gaps between the openings 131 and 133 and the end portions 111 and 112 of the magnetic wire 110, and are, for example, in a liquid state (a mixed liquid of a magnetically-soft powder and a resin). The magnetically-soft resins 140 are placed to fill the gaps between the openings 131 and 133 and the end portions 111 and 112 of the magnetic wire 110, and then are cured. As a result, the magnetically-soft resins 140 fill the gaps between the end portions 111 and 112 of the magnetic wire 110 and the openings 131 and 133 of the magnetically-soft components 130 and 132, and thus the end portions 111 and 112 of the magnetic wire 110 and the magnetically-soft components 130 and 132 are bonded to each other. The resin contained in the magnetically-soft resin 140 may be a resin that is cured by volatilization of a solvent, a resin that is cured by ultraviolet irradiation (a ultraviolet-curable resin), or a resin that is cured by heating (a thermosetting resin). In addition, a two-component liquid type adhesive in which a main agent and a curing agent are applied and placed to cure may be used.

Preferably, the magnetically-soft resin 140 is rubber-like and has elastic characteristics as resin characteristics after curing, particularly, flexible elastic characteristics in which the hardness is not higher than a durometer A90 (90 points in a type A durometer according to JIS K 6253). Since the magnetically-soft resin 140 is rubber-like and has elastic characteristics, even when the magnetically-soft components 130 and 132 are assembled to the magnetic wire 110, no stress is applied to the magnetic wire 110. In addition, since there is elasticity caused by the resin contained in the magnetically-soft resin 140, the magnetically-soft resins 140 are not peeled off at an interface between the magnetic wire 110 and the magnetically-soft components 130 and 132 even under influence of a temperature change, an external force, a vibration, and the like. Thus, the power generation sensor 100 as an assembly maintains high durability.

The magnetically-soft components 130 and 132 are made of a magnetically-soft material having a coercivity not higher than the coercivity of the magnetic wire 110 and having a relative permeability of not lower than 500. The magnetically-soft powder contained in the magnetically-soft resin 140 is also made of the same magnetically-soft material. This material has characteristic properties such as lower magnetic resistance, smaller hysteresis and lower self-dielectric property. Thereby, even if a high-frequency alternating magnetic field generated when the magnetic field source 400 is moved at a higher speed is applied, the output characteristics of the power generation sensor 100 are not significantly influenced. Specifically, the magnetically-soft components 130 and 132 and the magnetically-soft powder are preferably made of an Ni-based ferrite material or an Mn-based ferrite material.

A mixing ratio of the magnetically-soft powder in the magnetically-soft resin 140 is preferably not lower than 50 wt% and not higher than 90 wt%. In a case where the mixing ratio of the magnetically-soft powder is within the range, the resin characteristics such as viscosity, hardness, and curing, and the magnetically-soft powder characteristics such as permeability, a coercivity, and a magnetic flux density maintain the respective characteristics even after curing. The lower limit of the range is more preferably 55 wt%, still more preferably 60 wt%. The upper limit of the range is more preferably 85 wt%, still more preferably 80 wt%.

Since the magnetically-soft resin 140 is interposed between the magnetic wire 110 and the magnetically-soft components 130 and 132, the magnetic coupling between the magnetic wire 110 and the magnetically-soft components 130 and 132 is strengthened. Thereby, the demagnetization field at both end portions of the magnetic wire 110 is suppressed, and the magnetic field collected by the magnetically-soft components 130 and 132 can be induced in the axial direction X over a wide range of the magnetic wire 110 in the axial direction X.

A positional relationship between the pair of magnetically-soft components 130 and 132 and both end portions 111 and 112 of the magnetic wire 110 will be described. The pair of magnetically-soft components 130 and 132 are placed to be positioned between the magnetic wire 110 and the magnetic field source 400, and as seen from the axial direction X of the magnetic wire (refer to FIG. 1B), the centers of the pair of magnetically-soft components 130 and 132 are positioned on a straight line (the plane 116) drawn from the center of the magnetic wire 110 in the axially-orthogonal direction Z that is a direction opposing the magnetic field source 400. More specifically, it is considered the plane 116 (a virtual plane to be used to describe the geometric layout) that is parallel to the axially-orthogonal direction Z (a direction orthogonal to the axial direction X of the magnetic wire 110), which is a direction opposing the magnetic field source 400, and passes through the center of the magnetic wire 110 in a radial direction (including the central axis of the magnetic wire 110). Both end portions 111 and 112 of the magnetic wire 110 are placed on the plane 116. The relative placement of the magnetic wire 110 and the magnetically-soft components 130 and 132 is set such that the plane 116 passes through the centers of the pair of magnetically-soft components 130 and 132. Specifically, in FIG. 1B as seen in the axial direction X, the magnetic wire 110 is placed at a position of 1/2 of a width dimension w (a dimension in the width direction Y) of the magnetically-soft components 130 and 132. Since the both end portions 111 and 112 of the magnetic wire 110 are placed at the position, a magnetic flux collected from the magnetic field source 400 is uniformly induced to the magnetic wire 110. The center of each of the magnetically-soft components 130 and 132 may be the center of gravity of each of the magnetically-soft components 130 and 132 when it is assumed that each of the magnetically-soft components 130 and 132 is homogeneous (this assumption is generally valid).

Note that, in the illustrated example, the end portions 111 and 112 of the magnetic wire 110 are exposed from the magnetically-soft components 130 and 132. On the other hand, the end portions 111 and 112 may not be exposed from the magnetically-soft components 130 and 132. Further, in the illustrated example, the magnetically-soft resins 140 extend over the entire length range of a dimension L of each of the magnetically-soft components 130 and 132 in the axial direction X. On the other hand, the magnetically-soft resins 140 may be placed in the openings within a partial range of the dimension L in the axial direction. Furthermore, as illustrated in FIG. 1D, an arrangement may be employed in which the magnetically-soft resins 140 cover the end portions 111 and 112 of the magnetic wire 110 and fill a part of the openings 131 and 133. The same applies to modification examples to be described below.

### [Modification Example 1 of First Example Embodiment]

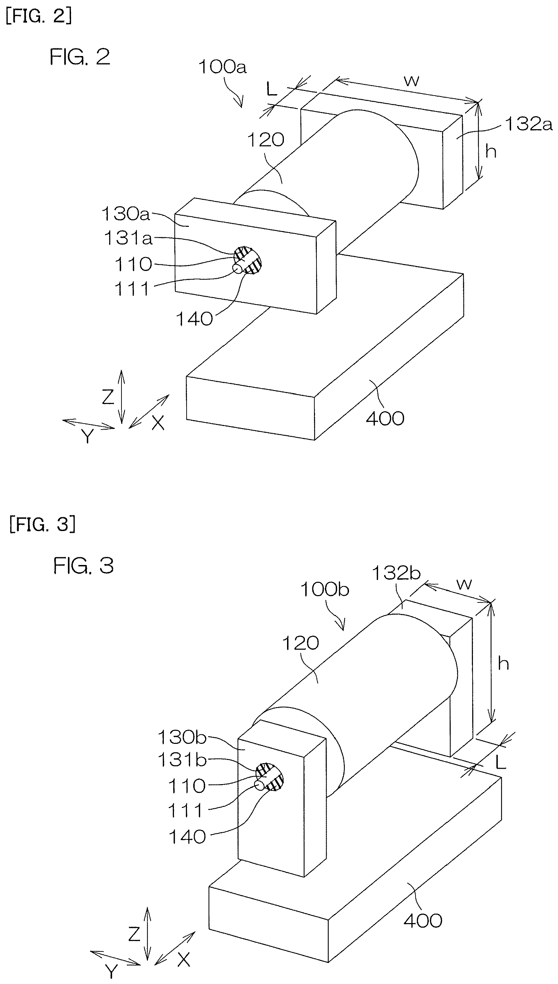

FIG. 2 illustrates a modification example 1 of the first example embodiment. Although the magnetically-soft components 130 and 132 according to the first example embodiment have a cylindrical shape, as in a power generation sensor 100a illustrated in FIG. 2, magnetically-soft components 130a and 132a may be provided in a rectangular parallelepiped shape. Similarly to the first example embodiment, in the magnetically-soft components 130a and 132a, circular-shaped openings 131a and 133a larger than the outer diameter of the magnetic wire 110 are formed, and the first end portion 111 and the second end portion 112 of the magnetic wire are respectively inserted into the openings 131a and 133a. The magnetically-soft resins 140 are placed in the openings 131a and 133a. The first end portion 111 of the magnetic wire 110 and the opening 131a of the magnetically-soft component 130a are bonded to each other by the magnetically-soft resin 140, and the second end portion 112 of the magnetic wire 110 and the opening 133a of the magnetically-soft component 132a are bonded to each other by the magnetically-soft resin 140. Thereby, the both end portions 111 and 112 of the magnetic wire 110 and the pair of magnetically-soft components 130a and 132a are bonded and fixed to each other.

As in the first embodiment, the magnetic wire 110 is placed at a position of 1/2 of the width dimension w (a dimension in the width direction Y) of the magnetically-soft components 130a and 132a. That is, the plane that passes through the central axis of the magnetic wire 110 and is parallel to the axially-orthogonal direction Z (refer to the plane 116 in FIG. 1) passes through the centers (typically, the centers of gravity) of the magnetically-soft components 130a and 132a.

The rectangular parallelepiped shape of the magnetically-soft components 130a and 132a is a form in which the width dimension w (the dimension in the width direction Y) that is parallel to a magnet surface of the magnetic field source 400 and is perpendicular to the axial direction X of the magnetic wire 110 is made longer than a dimension h in the axially-orthogonal direction Z that is a direction opposing the magnetic field source 400.

### [Modification Example 2 of First Example Embodiment]

FIG. 3 illustrates a modification example 2 of the first example embodiment. The shape of the magnetically-soft component is different from that of the power generation sensor 100a according to the modification example 1. More specifically, in the modification example 2, magnetically-soft components 130b and 132b have a rectangular parallelepiped shape in which the dimension h in the axially-orthogonal direction Z that is a direction opposing the magnetic field source 400 is made longer than the width dimension w (the dimension in the width direction Y) that is parallel to a magnet surface of the magnetic field source 400 and is perpendicular to the axial direction X of the magnetic wire 110. As in the first embodiment (FIG. 1A to FIG. 1D) and the modification example 1 (FIG. 2), the magnetic wire 110 is placed at a position of 1/2 of the width dimension w of the magnetically-soft components 130b and 132b. That is, the plane that passes through the central axis of the magnetic wire 110 and is parallel to the axially-orthogonal direction Z (refer to the plane 116 in FIG. 1) passes through the centers (typically, the centers of gravity) of the magnetically-soft components 130b and 132b. On the other hand, the positions of openings 131b and 133b of the magnetically-soft components 130b and 132b in the axially-orthogonal direction Z are offset toward a side opposite to the magnetic field source 400 from the center of the dimension h.

### [Modification Example 3 of First Example Embodiment]

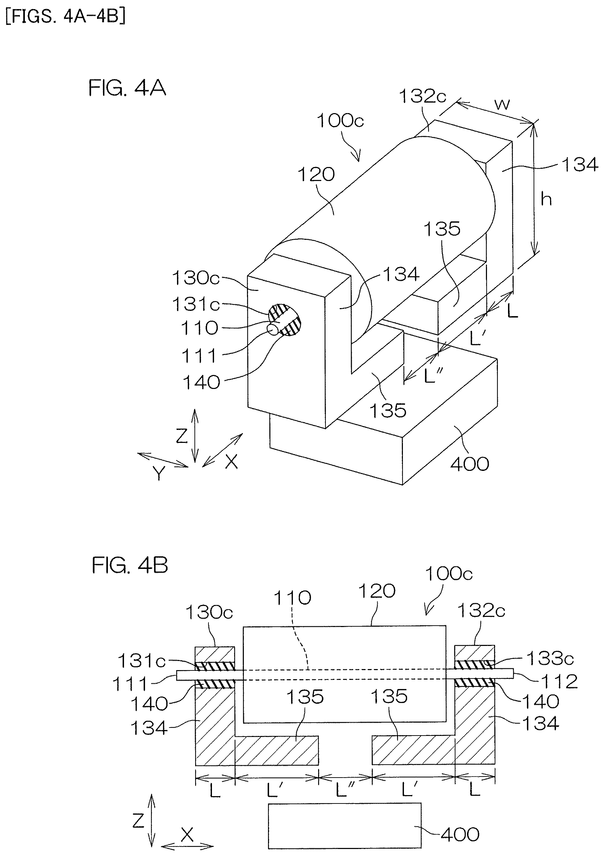

FIG. 4A and FIG. 4B illustrate a modification example 3 of the first example embodiment. Magnetically-soft components 130c and 132c of the power generation sensor 100c according to the modification example 3 include axially-orthogonal portions 134 corresponding to the magnetically-soft components 130b and 132b of the power generation sensor 100b (FIG. 3) according to the modification example 2, and axially-parallel portions 135 extending in the axial direction X of the magnetic wire 110 on a side toward the magnetic field source 400 and outside the outer diameter of the coil 120. In this example, the axially-parallel portion 135 that has a rectangular parallelepiped shape is connected to a distal end of the axially-orthogonal portion 134 that has a rectangular parallelepiped shape and is placed on the magnetic field source 400 side, and thus, the L-shaped magnetically-soft components 130c and 132c are configured. The axially-orthogonal portion 134 has the dimension L in the axial direction X. The axially-parallel portions 135 of the pair of magnetically-soft components 130c and 132c extend from the axially-orthogonal portions 134 toward each other along the axial direction X by a dimension L'. A gap having a dimension L'' is formed between proximal ends of the axially-parallel portions 135 at the center position in the axial direction X. The axially-parallel portions 135 have a magnetic shielding function of preventing the magnetic field from the magnetic field source 400 from entering an intermediate portion of the magnetic wire 110 in the axial direction X, a magnetism collecting function of collecting the magnetic field from the magnetic field source 400, and a magnetic induction function of inducing the collected magnetic field to the end portions 111 and 112 of the magnetic wire 110 through the axially-orthogonal portions 134. The positions of the openings 131c and 133c of the magnetically-soft components 130c and 132c in the axially-orthogonal direction Z are offset toward a side opposite to the magnetic field source 400 from the center of the dimension h.

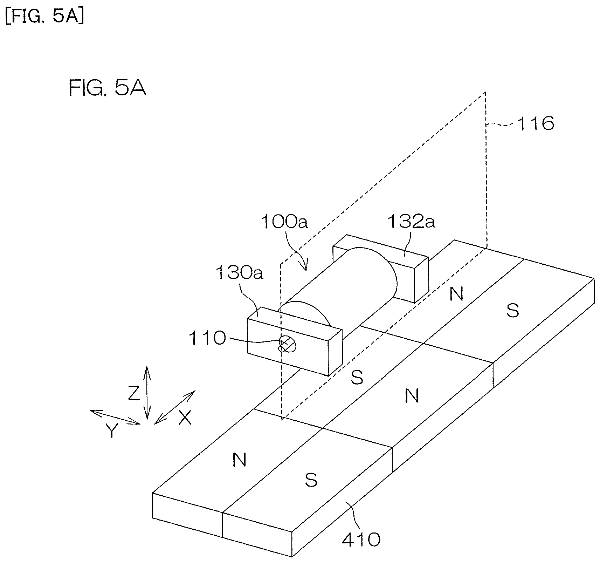

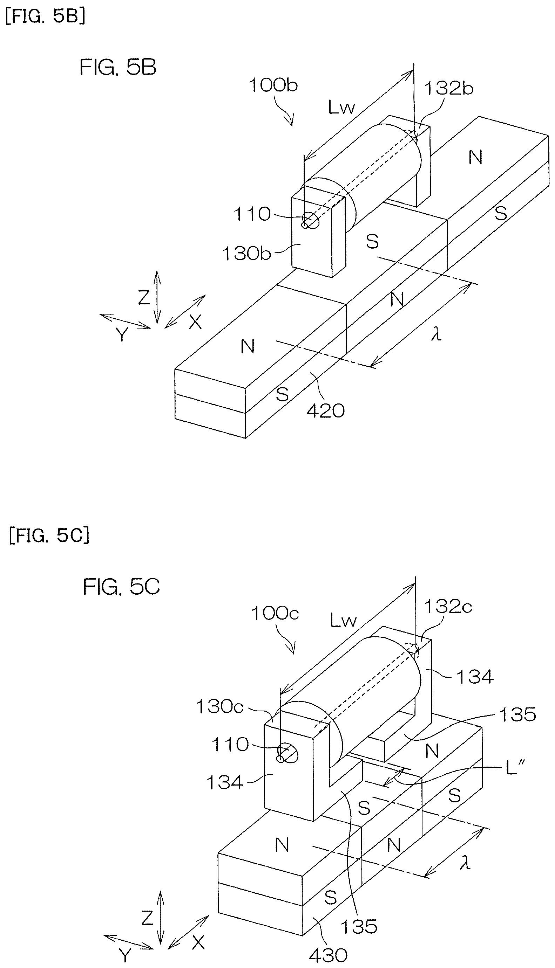

FIG. 5A, FIG. 5B, and FIG. 5C illustrate examples of devices that respectively use the power generation sensors 100a, 100b, and 100c according to the modification examples 1, 2, and 3. These devices are provided as encoder devices in which the magnetic field source 400 is used as a magnet 410, 420, or 430, and the magnet 410, 420, or 430 relatively moves (linearly moves in this example) in the axial direction X of the magnetic wire 110 of the power generation sensor 100a, 100b, or 100c.

FIG. 5A is a perspective view of the encoder device using the power generation sensor 100a according to the modification example 1. The magnet 410 as the magnetic field source 400 is a multi-pole magnet that is magnetized in the width direction Y. The pair of magnetically-soft components 130a and 132a of the power generation sensor 100a extend long in the width direction Y, and thus, the magnetism collecting effect of the magnetically-soft components 130a and 132a from the magnet 410 that is magnetized in the width direction Y is enhanced. Therefore, there is an advantage that the device itself can be made thin and small in size in the axially-orthogonal direction Z. Note that the power generation sensor 100a needs to be placed to be offset with respect to the magnet 410 in the width direction Y such that the respective magnetically-soft components 130a and 132a do not simultaneously oppose an N pole and an S pole of the magnet 410.

FIG. 5B is a perspective view of the encoder device using the power generation sensor 100b according to the modification example 2. The magnet 420 as the magnetic field source 400 is a multi-pole magnet that is magnetized in the axially-orthogonal direction Z. The pair of magnetically-soft components 130b and 132b of the power generation sensor 100b extend long in the axially-orthogonal direction Z, and thus, the magnetism collecting effect from the magnet 420 that is magnetized in the axially-orthogonal direction Z is enhanced. Therefore, there is an advantage that the device itself can be made thin and small in size in the width direction Y.

FIG. 5C is a perspective view of the encoder device using the power generation sensor 100c according to the modification example 3. The magnet 430 as the magnetic field source 400 is a multi-pole magnet that is magnetized in the axially-orthogonal direction Z. The pair of magnetically-soft components 130c and 132c of the power generation sensor 100c have an L-shape and include the axially-parallel portions 135 that are provided on a side opposing the magnet 430 in the axially-orthogonal direction Z. The magnetism collecting effect of the magnetically-soft components 130c and 132c from the magnet 430 that is magnetized in the axially-orthogonal direction Z is enhanced. Therefore, there is an advantage that the device itself can be made thin and small in size in the width direction Y.

Further, unlike the power generation sensor 100b, since the magnetically-soft components 130c and 132c have an L shape, an area of the magnetically-soft components 130c and 132c opposing the magnet 430 is large, and thus, a shield function acts in addition to the magnetism collecting function. Therefore, as illustrated in FIG. 5B, in the power generation sensor 100b, a magnetization pitch λ (a gap between the centers of the N pole and the S pole) of the magnet 420 needs to be equal to or longer than a length Lw of the magnetic wire 110. On the other hand, in a case of the power generation sensor 100c, as illustrated in FIG. 5C, the magnetization pitch λ of the magnet 430 can be designed to be equal to or shorter than the length Lw of the magnetic wire 110 as long as the magnetization pitch λ is equal to or longer than the dimension L" of the gap between the pair of magnetically-soft components 130c and 132c. Therefore, in a case where the magnet 420 or 430 moves relative to the power generation sensor 100b or 100c by the same distance, the number of pulse signals output from the power generation sensor 100c of the encoder device in FIG. 5C is larger than the number of pulse signals output from the power generation sensor 100b of the encoder device in FIG. 5B. That is, position detection with high resolution can be performed.

### [Model]

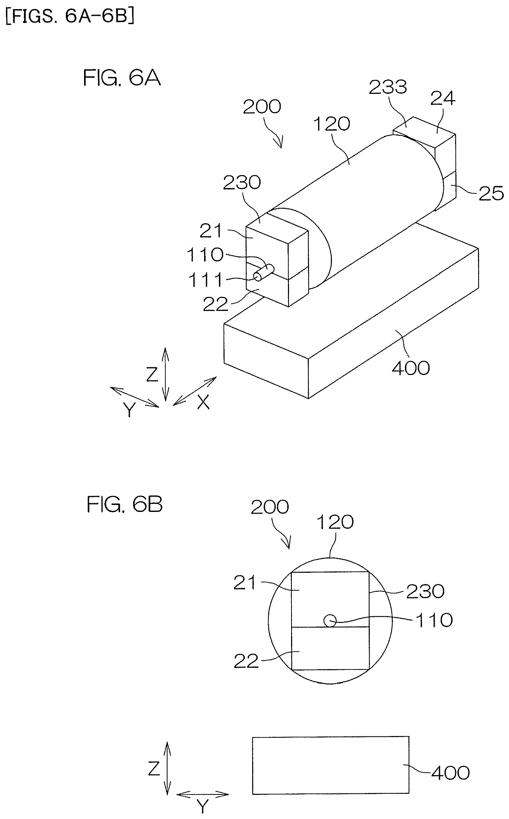

In order to facilitate understanding of a second example embodiment to be described next, a model structure (comparative example) in FIG. 6A and FIG. 6B will be described. A power generation sensor 200 includes the magnetic wire 110 that exhibits a large Barkhausen effect by a magnetic field applied by a relative movement with respect to the magnetic field source 400, the coil 120 wound around the magnetic wire 110, and a pair of magnetically-soft components 230 and 233 having a rectangular parallelepiped shape. The coil 120 is wound around the magnetic wire 110 such that a first end portion 111 and a second end portion 112 of the magnetic wire 110 are exposed with the same length from the coil 120. In the model, the coil 120 is wound around the magnetic wire 110 between the pair of magnetically-soft components 230 and 233. In the pair of magnetically-soft components 230 and 233, circular-shaped openings having the same outer diameter as the outer diameter of the magnetic wire 110 are formed, and the first end portion 111 and the second end portion 112 of the magnetic wire are respectively inserted into the openings.

When the pair of magnetically-soft components 230 and 233 are divided by a virtual plane that extends in the width direction Y and includes the central axis of the magnetic wire 110, the magnetically-soft components 230 and 233 are divided into portions 22 and 25 on a side that opposes the magnetic field source 400 and portions 21 and 24 on a side that does not oppose the magnetic field source 400. In this case, the portions 21 and 24 on the side that does not oppose the magnetic field source 400 do not have a function of collecting the magnetic field from the magnetic field source 400, but contribute to magnetic coupling between the magnetically-soft components 230 and 233 and the magnetic wire 110. In a case where there are not the portions 21 and 24 on the side that does not oppose the magnetic field source 400, portions where the portions 22 and 25 on the side that opposes the magnetic field source 400 and the magnetic wire 110 are in contact with each other are narrow and small. As a result, the magnetic coupling between the portions 22 and 25 and the magnetic wire 110 is weak, and the pulse signal caused by the large Barkhausen effect may not be stable.

### [Second Example Embodiment]

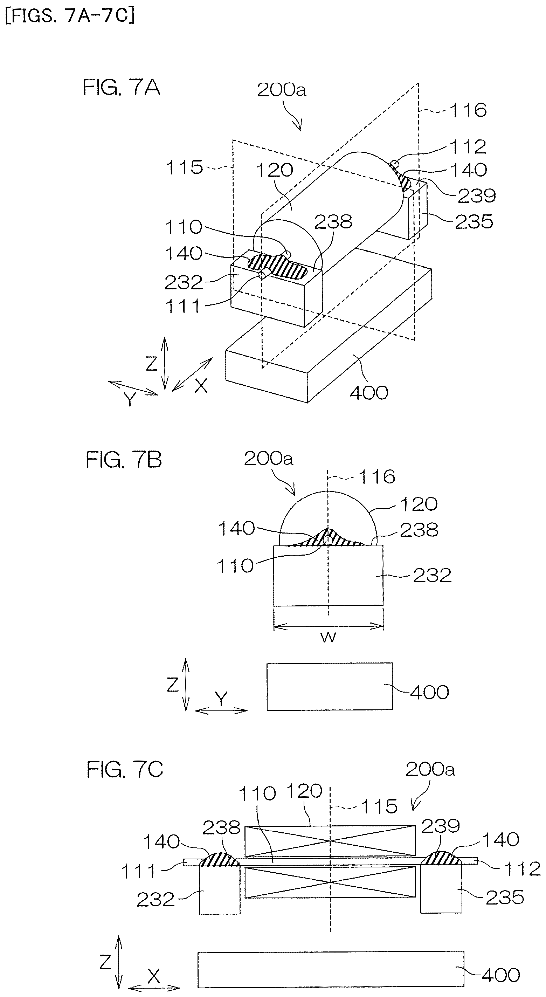

FIG. 7A is a perspective view of a power generation sensor 200a according to a second example embodiment, FIG. 7B is a front view of the power generation sensor 200a as seen in the axial direction X, and FIG. 7C is a cross-sectional view of a cut surface of the power generation sensor 200a on the plane 116 of FIG. 7A as seen from the width direction Y.

The power generation sensor 200a includes the magnetic wire 110 that exhibits a large Barkhausen effect by a magnetic field applied by a relative movement with respect to the magnetic field source 400, the coil 120 wound around the magnetic wire 110, and a pair of magnetically-soft components 232 and 235. The coil 120 is wound around the magnetic wire 110 such that a first end portion 111 and a second end portion 112 of the magnetic wire 110 are exposed with the same length from the coil 120. In this example embodiment, the coil 120 is wound around the magnetic wire 110 between the pair of magnetically-soft components 232 and 235. The pair of magnetically-soft components 232 and 235 are positioned between the magnetic wire 110 and the magnetic field source 400. The first end portion 111 and the second end portion 112 of the magnetic wire 110 are placed on respective surfaces 238 and 239 of the pair of magnetically-soft components 232 and 235 that do not oppose the magnetic field source 400, and are respectively bonded and fixed to the pair of magnetically-soft components 232 and 235 by magnetically-soft resins 140.

The pair of magnetically-soft components 232 and 235 have the same structure in a rectangular parallelepiped shape, and are configured to be symmetrical to each other with respect to the symmetry plane 115 (the virtual plane for describing the geometric placement) orthogonal to the axial direction X at the center of the magnetic wire 110 in the axial direction X. Considering the plane 116 (a virtual plane to be used to describe the geometric layout) that is parallel to the axially-orthogonal direction Z, which is a direction opposing the magnetic field source 400, and passes through the center of the magnetic wire 110 in a radial direction (including the central axis of the magnetic wire 110), the centers (typically, the centers of gravity) of the pair of magnetically-soft components 232 and 235 are placed on the plane 116. Specifically, in FIG. 7B, the magnetic wire 110 is placed at a position of 1/2 of the width dimension w (the dimension in the width direction Y) of the magnetically-soft components 232 and 235.

Coating films having a thickness of the magnetically-soft resin 140 cover a part or the whole of the respective surfaces 238 and 239 of the pair of magnetically-soft components 232 and 235 that do not oppose the magnetic field source 400, and cover the end portions 111 and 112 of the magnetic wire 110 over the entire circumference of the magnetic wire 110 by filling gaps between the surfaces 238 and 239 and the end portions 111 and 112 of the magnetic wire 110.

Since the coating film having a thickness of the magnetically-soft resin 140 is interposed between the magnetic wire 110 and the magnetically-soft components 232 and 235, the magnetic coupling between the magnetic wire 110 and the magnetically-soft components 232 and 235 is strengthened. With this arrangement, the demagnetization field at both end portions of the magnetic wire 110 is suppressed, and the magnetic flux collected by the magnetically-soft components 232 and 235 can induce a magnetic field in the axial direction X over a wide range of the magnetic wire 110 in the axial direction X. In addition, since the magnetically-soft resin 140 has elasticity, even in a case where the magnetically-soft components 232 and 235 are assembled to the magnetic wire 110, unintended stress is not applied to the magnetic wire 110. Further, the magnetically-soft resins 140 are not peeled off at an interface between the magnetic wire 110 and the magnetically-soft components 232 and 235 even under environments such as a temperature change, an external force, and a vibration. Thus, the power generation sensor 200a as an assembly maintains high durability.

One advantage of the second example embodiment is an assembly process of the power generation sensor. An example of the assembly process includes a process of inserting the magnetic wire 110 into the coil 120, a process of placing both end portions 111 and 112 of the magnetic wire 110 at predetermined positions on the surfaces 238 and 239 of the pair of magnetically-soft components 232 and 235, and a subsequent process of applying the magnetically-soft resins 140 onto both end portions 111 and 112 of the magnetic wire 110 by potting, printing, transferring, or the like.

On the other hand, an example of the assembly process of the power generation sensor 100 according to the first example embodiment includes a process of inserting the magnetic wire 110 into the coil 120, a process of inserting the magnetic wire 110 into the openings 131 and 133 of the magnetically-soft components 130 and 132, and a process of injecting the magnetically-soft resins 140 into the openings 131 and 133 before or after the insertion of the magnetic wire 110.

Unlike the model of FIG. 6, the magnetically-soft components 232 and 235 according to the second example embodiment do not include structural portions corresponding to the portions 21 and 24 on the side that does not oppose the magnetic field source 400, and are configured to be opened to the side that does not oppose the magnetic field source 400. Therefore, in the second example embodiment, it is not necessary to insert the magnetic wire 110 into the openings. In addition, a separate component for pressing the magnetic wire 110 and bringing the magnetic wire 110 into contact with the magnetically-soft component is not necessary, and thus, assembly is facilitated. With this arrangement, it is possible to provide a power generation sensor capable of reducing a manufacturing cost.

### [Modification Example 1 of Second Example Embodiment]

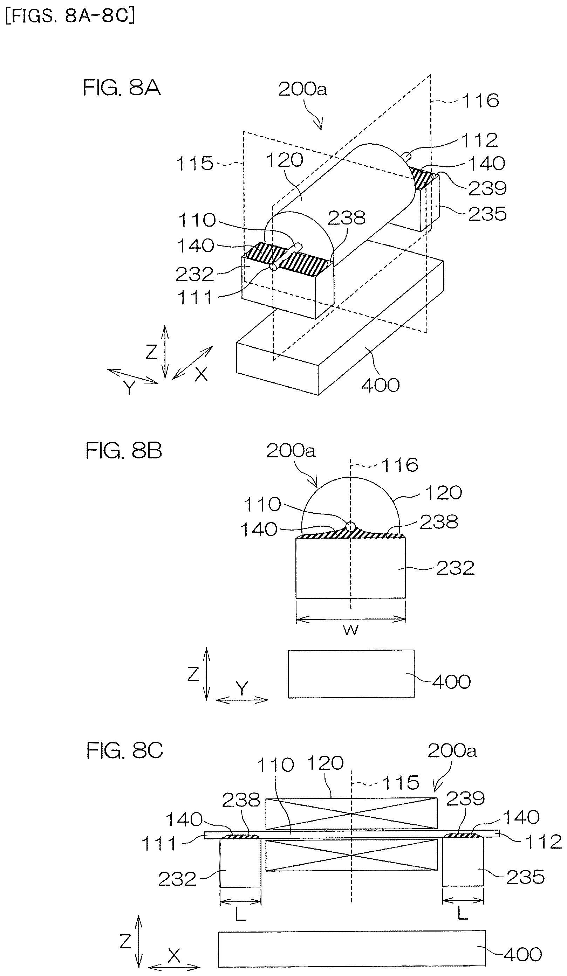

FIG. 8A, FIG. 8B, and FIG. 8C illustrate a modification example 1 of the second example embodiment. FIG. 8A, FIG. 8B, and FIG. 8C are a perspective view, a front view, and a cross-sectional view similar to FIG. 7A, FIG. 7B, and FIG. 7C, respectively.

The modification example 1 differs from the second example embodiment in an assembling process, and according to the difference in the assembling process, a difference appears in a structure. In the modification example 1, first, the magnetically-soft resins 140 are applied onto the surfaces 238 and 239 of the pair of magnetically-soft components 232 and 235 by potting, printing, transferring, or the like. Thereafter, both end portions 111 and 112 of the magnetic wire 110 are placed on the magnetically-soft resins 140. The coating films having a thickness of the magnetically-soft resin 140 are in contact with regions having a dimension equal to or shorter than approximately half the outer circumference of each of the end portions 111 and 112 of the magnetic wire 110, and are in contact with a part or the whole of the surfaces 238 and 239 of the pair of magnetically-soft components 232 and 235 that do not oppose the magnetic field source 400. As described above, a part of the end portions 111 and 112 of the magnetic wire 110 may be exposed from the magnetically-soft resins 140. The magnetically-soft resins 140 cover most (preferably, all) of the dimension L of the end portions 111 and 112 of the magnetic wire 110 in the axial direction, and the regions in contact with the end portions 111 and 112 are effectively used for magnetic coupling. Thus, the magnetic coupling function and the stress prevention function can be effectively exhibited. With this arrangement, first, the magnetically-soft resins 140 are placed, and thus, assembly is further facilitated.

### [Modification Example 2 of Second Example Embodiment]

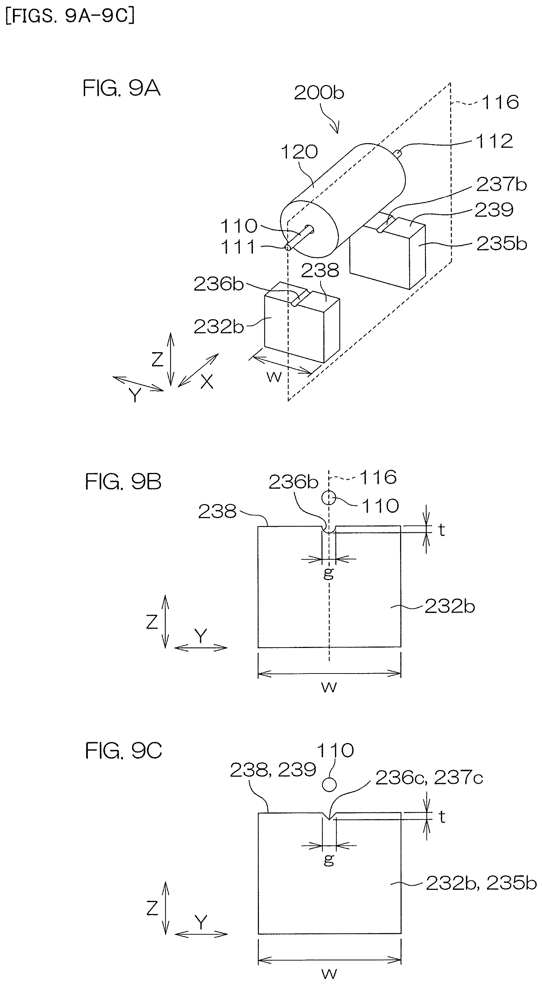

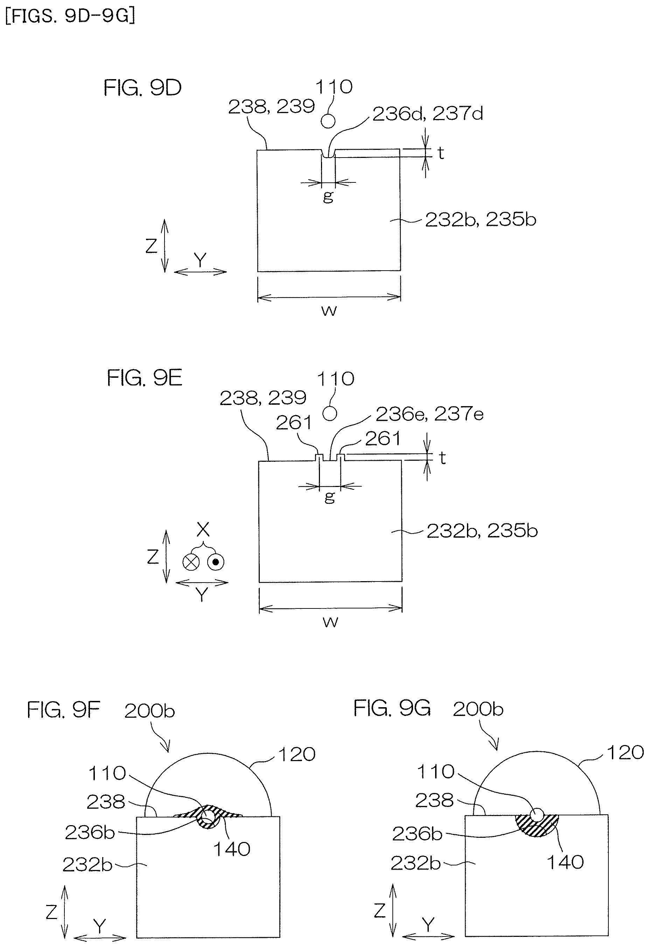

FIGS. 9A, 9B, 9C, 9D, 9E, 9F, and 9G illustrate a modification example 2 of the second example embodiment.

In a power generation sensor 200b illustrated in the perspective view of FIG. 9A and the front view in FIG. 9B as seen in the axial direction X, instead of the pair of magnetically-soft components 232 and 235 according to the second example embodiment, a pair of magnetically-soft components 232b and 235b, which are provided with grooves 236b and 237b having a semicircular cross section (U-shape) extending in the axial direction X of the magnetic wire 110 on the surfaces 238 and 239 that do not oppose the magnetic field source 400, are used. The relative placement of the magnetic wire 110 and the magnetically-soft components 232b and 235b is set such that the plane 116 (a virtual plane to be used to describe the geometric layout) that is parallel to the axially-orthogonal direction Z, which is a direction opposing the magnetic field source 400, and passes through the center of the magnetic wire 110 in the radial direction (including the central axis) passes through the center (typically, the center of gravity) of the pair of magnetically-soft components 232b and 235b. Accordingly, the grooves 236b and 237b having a semicircular cross section extending in the axial direction X of the magnetic wire 110 are placed on the plane 116. Specifically, in FIG. 9B, the grooves 236b and 237b are at positions of 1/2 of the width dimension w (the dimension in the width direction Y) of the magnetically-soft components 232b and 235b.

The grooves may be grooves 236c and 237c having a triangular (V-shaped) cross section illustrated in FIG. 9C or grooves 236d and 237d having a square (U-shaped) cross section illustrated in FIG. 9D.

Further, as illustrated in FIG. 9E, a pair of ridges 261 protruding from the surfaces 238 and 239 in the axially-orthogonal direction Z and extending in the axial direction X may be provided in parallel at intervals in the width direction Y, and grooves 236e and 237e may be formed between the ridges 261.

The grooves 236b and 237b, 236c and 237c, 236d and 237d, and 236e and 237e illustrated in FIG. 9B to FIG. 9E each have an opening width dimension g (a dimension in the width direction Y) equal to or larger than the outer diameter of the magnetic wire 110. These arrangements have an advantage of facilitating positioning of both end portions 111 and 112 of the magnetic wire 110. A depth dimension t (a dimension in the axially-orthogonal direction Z) of the grooves 236b and 237b, 236c and 237c, 236d and 237d, and 236e and 237e is not particularly limited as long as the positioning function is not impaired.

In an arrangement shown in FIG. 9E, only one ridge 261 may be provided, and the purpose of positioning the magnetic wire 110 can be achieved. Here, provided that, the arrangement including the two ridges 261 has an advantage that the magnetic coupling between the magnetically-soft components 232b and 235b and the magnetic wire 110 is strengthened.

As illustrated in FIG. 9F, thick coating films of the magnetically-soft resins 140 may cover the entire circumference of the outer circumference of the end portions 111 and 112 of the magnetic wire 110, and may cover the inside of the grooves 236b of the pair of magnetically-soft components 232b. Alternatively, as illustrated in FIG. 9G, the coating films having a thickness of the magnetically-soft resin 140 may be placed between regions having a dimension equal to or shorter than approximately half the outer circumference of the end portions 111 and 112 of the magnetic wire 110 and the inner surfaces of the grooves 236b of the pair of magnetically-soft components 232b and 235b. In either arrangement, the magnetically-soft resin 140 can exhibit the magnetic coupling function and the stress prevention function.

### [Modification Example 3 of Second Example Embodiment]

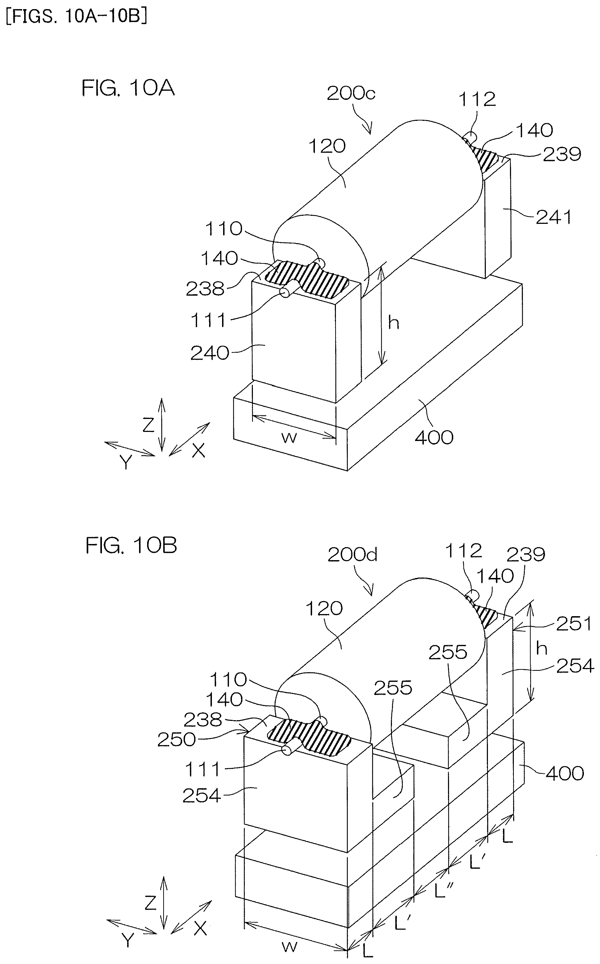

Also in the second example embodiment, the same arrangement as the arrangement of the modification examples of the first example embodiment can be adopted. FIG. 10A illustrates one power generation sensor 200c according to a modification example 3 of the second example embodiment, and FIG. 10B illustrates another power generation sensor 200d according to the modification example 3 of the second example embodiment.

A pair of magnetically-soft components 240 and 241 of the power generation sensor 200c in FIG. 10A have a rectangular parallelepiped shape in which the dimension h in the axially-orthogonal direction Z that is a direction opposing the magnetic field source 400 is made longer than the width dimension w (the dimension in the width direction Y) that is parallel to a magnet surface of the magnetic field source 400 and is perpendicular to the axial direction X of the magnetic wire 110.

Magnetically-soft components 250 and 251 of the power generation sensor 200d in FIG. 10B include axially-orthogonal portions 254 coupled to both end portions of the magnetic wire 110 and axially-parallel portions 255 extending in the axial direction X of the magnetic wire 110 on the magnetic field source 400 side and outside the outer diameter of the coil 120. In this example, the axially-parallel portion 255 that has a rectangular parallelepiped shape is connected to a distal end of the axially-orthogonal portion 254 that has a rectangular parallelepiped shape and is placed on the magnetic field source 400 side, and thus, the L-shaped magnetically-soft components 250 and 251 are configured. The axially-orthogonal portion 254 has the dimension L in the axial direction X. The axially-parallel portions 255 of the pair of magnetically-soft components 130c and 132c extend from the axially-orthogonal portions 254 toward each other along the axial direction X by the dimension L'. A gap having the dimension L'' is formed between proximal ends of the axially-parallel portions 255 at the center position in the axial direction X.

When these two power generation sensors 200c and 200d are used in the encoder device, the same advantages as those of the modification example of the first example embodiment can be obtained (refer to FIG. 5B and FIG. 5C).

In the explanatory diagrams of the second example embodiment and the modification example, the end portions 111 and 112 of the magnetic wire 110 are exposed from the magnetically-soft components 232 and 235, 232b and 235b, 240 and 241, and 250 and 251, but the end portions 111 and 112 may not be exposed from the magnetically-soft components 232 and 235, 232b and 235b, 240 and 241, and 250 and 251.

### [Third Example Embodiment]

In a case where the pair of magnetically-soft components of the power generation sensor have a rectangular parallelepiped shape or an L shape, the pair of magnetically-soft components have a flat surface on a side opposing the magnetic field source, and thus, the flat surface can be used as a surface mounting area.

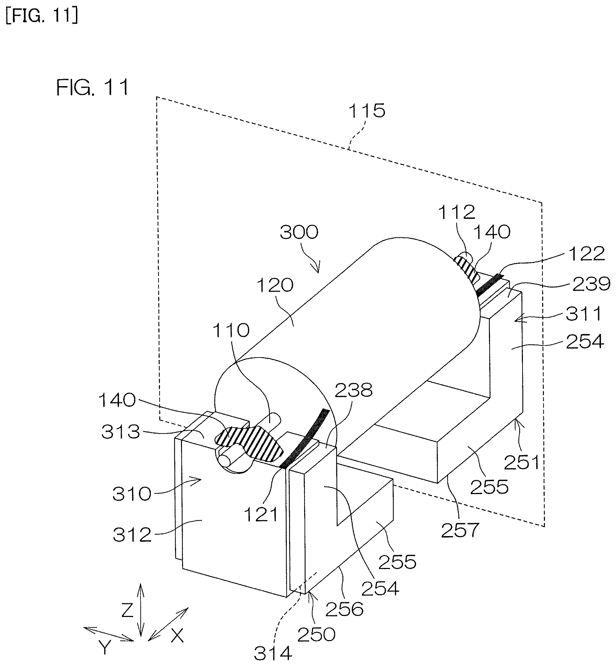

FIG. 11 is a perspective view for explaining an arrangement of a power generation sensor 300 according to a third embodiment. In the description of the third example embodiment, components are denoted by reference numerals corresponding to the components of the modification example 3 (refer to FIG. 10B) of the second example embodiment described above.

In the power generation sensor 300 according to the third embodiment, surface-mountable external terminal electrodes are directly provided on the magnetically-soft components 250 and 251. The external terminal electrodes are configured by lead frames 310 and 311. The lead frames 310 and 311 are formed so as to conform to the shapes of the magnetically-soft components 250 and 251.

More specifically, the lead frames 310 and 311 are configured to be substantially symmetrical with respect to the symmetry plane 115 (a virtual plane to be used to describe the geometric layout) orthogonal to the axial direction X at the center of the magnetic wire 110 in the axial direction X. The lead frame 310 or 311 is configured to include a side surface portion 312 orthogonal to the axial direction X along an outer side surface of the magnetically-soft component 250 or 251, a flat top surface portion 313 extending inward in the axial direction X along a surface 238 or 239 on which the magnetic wire 110 is placed from one edge of the side surface portion 312, and a flat bottom surface portion 314 extending inward in the axial direction X along a surface 256 or 257 on a side opposing the magnetic field source, and has a horizontal U-shaped arrangement.

The lead frame 310 or 311 has a structure that avoids an application region of the magnetically-soft resin 140 placed by application using potting, printing, transferring, or the like. Thereby, it is configured such that the function of the magnetically-soft resin 140 that magnetically couples the magnetically-soft components 250 and 251 and the magnetic wire 110 is not impaired. On the surfaces 238 and 239 of the magnetically-soft components 250 and 251 on which the magnetic wire 110 is placed, terminal wires 121 and 122 of the coil 120 are connected to the lead frames 310 and 311 by soldering, resistance welding, or the like on the exposed surfaces of the top surface portions 313 of the lead frames 310 and 311.

Therefore, the power generation sensor 300 can be surface-mounted by bonding the flat bottom surface portions 314 of the lead frames 310 and 311 on the side opposing the magnetic field source to a printed circuit board or the like. As described above, the external terminal electrodes are configured using the lead frames 310 and 311 in direct contact with the magnetically-soft components 250 and 251, and thus, the number of components configuring the power generation sensor 300 is reduced. Therefore, it is possible to provide the power generation sensor 300 that has a simple structure and a small size and can be surface-mounted.

Although the example in which the external terminal electrodes are configured using the lead frames 310 and 311 has been described, the external terminal electrodes may be configured using a plating layer, a conductive paste layer, a solder layer, or the like. In a case where the magnetic wire 110 is a conductor, the external terminal electrodes are in direct contact with the magnetically-soft components, and thus, the magnetically-soft components and/or the magnetically-soft resins are insulators. Specifically, the magnetically-soft material of the magnetically-soft powder in the magnetically-soft component and/or the magnetically-soft resin is preferably an Ni-based ferrite material.

In an arrangement shown in FIG. 11, since the magnetically-soft resins 140 are in contact with the lead frames 310 and 311, it is necessary that both the magnetically-soft components 250 and 251 and the magnetically-soft resins 140 are insulators. On the other hand, in a case where the magnetically-soft resins 140 are not in contact with the lead frames 310 and 311, when at least one of the magnetically-soft component 250 or 251 or the magnetically-soft resin 140 is an insulator, the lead frames 310 and 311 and the magnetic wire 110 are insulated. The same applies to a case where the external terminal electrodes are configured using a conductive layer such as a plating layer.

In the above description, a linear motion type encoder device has been described as an example of the encoder device in which the power generation sensor is used. On the other hand, the power generation sensor according to the present invention can also be applied to a rotary type encoder device that detects a rotational movement of the magnet.

While the present invention has been described in detail by way of the example embodiments thereof, it should be understood that these example embodiments are merely illustrative of the technical principles of the present invention but not limitative of the invention. The scope of the present invention is to be limited only by the appended claims.

### DESCRIPTION OF REFERENCE CHARACTERS

100, 100a, 100b, 100c: Power generation sensor
110: Magnetic wire
111: First end portion
112: Second end portion
116: Plane
120: Coil
130, 130a, 130b, 130c: Magnetically-soft component
131, 131a, 131b: Opening
132, 132a, 132b, 132c: Magnetically-soft component
133, 133a, 133b: Opening
134: Axially-orthogonal portion
135: Axially-parallel portion
140: Magnetically-soft resin
200, 200a, 200b, 200c, 200d: Power generation sensor
230, 232, 232b, 233, 235, 235b: Magnetically-soft component
236b, 236c, 236d, 236e, 237b, 237c, 237d, 237e: Groove
238, 239: Plane
240, 241, 250, 251: Magnetically-soft component
254: Axially-orthogonal portion
255: Axially-parallel portion
261: Ridge
300: Power generation sensor
310, 311: Lead frame
400: Magnetic field source
410, 420, 430: Magnet
X: Axial direction
Y: Width direction
Z: Axially-orthogonal direction

## Claims

1. A power generation sensor comprising:
a magnetic wire configured to exhibit a large Barkhausen effect by an alternating magnetic field applied by a magnetic field source;
a coil wound around the magnetic wire; and
a pair of magnetically-soft components that are respectively magnetically coupled to both end portions of the magnetic wire; wherein
the pair of magnetically-soft components are bonded and fixed to both end portions of the magnetic wire by magnetically-soft resins made of a resin containing a magnetically-soft material.

2. The power generation sensor according to claim 1, wherein
the pair of magnetically-soft components are placed to be positioned between the magnetic wire and the magnetic field source, and
the both end portions of the magnetic wire and surfaces of the pair of magnetically-soft components that do not oppose the magnetic field source are bonded and fixed to each other by the magnetically-soft resins.

3. The power generation sensor according to claim 1 or 2, wherein
hardness of the magnetically-soft resin is not higher than durometer A90.

4. The power generation sensor according to any one of claims 1 to 3, wherein
the pair of magnetically-soft components are made of a magnetically-soft material, which has a coercivity not higher than that of the magnetic wire and has a relative permeability of not lower than 500, and
the magnetically-soft resin is a resin obtained by mixing a magnetically-soft powder made of a magnetically-soft material, which has a coercivity not higher than that of the magnetic wire and has a relative permeability of not lower than 500.

5. The power generation sensor according to claim 4, wherein
a mixing ratio of the magnetically-soft powder in the magnetically-soft resin is not lower than 50 wt% and not higher than 90 wt%.

6. The power generation sensor according to any one of claims 1 to 5, wherein
the pair of magnetically-soft components include rectangular parallelepiped portions.

7. The power generation sensor according to any one of claims 1 to 6, wherein
the pair of magnetically-soft components include axially-parallel portions that extend in an axial direction of the magnetic wire between the magnetic field source and the coil.

8. The power generation sensor according to any one of claims 1 to 7, wherein
the pair of magnetically-soft components are placed to be positioned between the magnetic wire and the magnetic field source, and as seen from an axial direction of the magnetic wire, centers of the pair of magnetically-soft components are positioned on a straight line drawn from a center of the magnetic wire in a direction opposing the magnetic field source.

9. The power generation sensor according to any one of claims 1 to 8, wherein
the pair of magnetically-soft components are placed to be positioned between the magnetic wire and the magnetic field source,
the both end portions of the magnetic wire and surfaces of the pair of magnetically-soft components that do not oppose the magnetic field source are bonded and fixed to each other by the magnetically-soft resins, and
the pair of magnetically-soft components have grooves or ridges that extend in an axial direction of the magnetic wire on surfaces which do not oppose the magnetic field source.

10. The power generation sensor according to any one of claims 1 to 9, further comprising:
a pair of surface-mounting external terminal electrodes that are respectively provided on the pair of magnetically-soft components so as to oppose the magnetic field source, wherein
at least one of the pair of magnetically-soft components or the magnetically-soft resin is an insulator.
